(19) Europäisches Patentamt
European Patent Office
Office européen des brevets

(11) EP 1 378 013 B1

## (12) EUROPÄISCHE PATENTSCHRIFT

(45) Veröffentlichungstag und Bekanntmachung des Hinweises auf die Patenterteilung:
**30.09.2015 Patentblatt 2015/40**

(51) Int Cl.:
*H01L 33/60* (2010.01)          *H01L 33/64* (2010.01)
*H01L 33/62* (2010.01)

(21) Anmeldenummer: 02761866.9

(22) Anmeldetag: **09.04.2002**

(86) Internationale Anmeldenummer:
**PCT/DE2002/001306**

(87) Internationale Veröffentlichungsnummer:
**WO 2002/084749 (24.10.2002 Gazette 2002/43)**

(54) **GEHÄUSE FÜR EIN STRAHLUNGSEMITTIERENDES BAUELEMENT, STRAHLUNGSEMITTIERENDES BAUELEMENT SOWIE VERFAHREN ZU DESSEN HERSTELLUNG**

HOUSING FOR A RADIATION-EMITTING COMPONENT, RADIATION EMITTING COMPONENT AND METHOD FOR PRODUCING THE SAME

BOITIER POUR UN ELEMENT EMETTANT UN RAYONNEMENT, ELEMENT EMETTANT UN RAYONNEMENT AINSI QUE PROCEDE DE FABRICATION DUDIT ELEMENT

(84) Benannte Vertragsstaaten:
**DE**

(30) Priorität: **10.04.2001 DE 10117889**

(43) Veröffentlichungstag der Anmeldung:
**07.01.2004 Patentblatt 2004/02**

(73) Patentinhaber: **OSRAM Opto Semiconductors GmbH
93055 Regensburg (DE)**

(72) Erfinder:
• **BOGNER, Georg
93138 Lappersdorf (DE)**
• **BRUNNER, Herbert
93047 Regensburg (DE)**
• **HIEGLER, Michael
93049 Regensburg (DE)**
• **WAITL, Günter
93049 Regensburg (DE)**
• **HÄNGGI, Rolf
4532 Feldbrunnen (CH)**

(74) Vertreter: **Epping - Hermann - Fischer Patentanwaltsgesellschaft mbH
Schloßschmidstraße 5
80639 München (DE)**

(56) Entgegenhaltungen:
**EP-A- 1 139 439      EP-A- 1 139 439**

WO-A-00/55914      WO-A1-98/20718
DE-A- 2 315 709      DE-A- 2 315 709
DE-A- 4 017 697      DE-A1- 19 945 675

• PATENT ABSTRACTS OF JAPAN Bd. 2000, Nr. 13, 5. Februar 2001 (2001-02-05) & JP 2000 294832 A (MATSUSHITA ELECTRONIC), 20. Oktober 2000 (2000-10-20)
• PATENT ABSTRACTS OF JAPAN Bd. 1999, Nr. 02, 26. Februar 1999 (1999-02-26) -& JP 10 303464 A (CITIZEN ELECTRON CO), 13. November 1998 (1998-11-13)
• PATENT ABSTRACTS OF JAPAN Bd. 1995, Nr. 11, 26. Dezember 1995 (1995-12-26) -& JP 07 202271 A (MATSUSHITA ELECTRIC), 4. August 1995 (1995-08-04)
• PATENT ABSTRACTS OF JAPAN Bd. 2000, Nr. 03, 30. März 2000 (2000-03-30) -& JP 11 346006 A (ROHM CO LTD), 14. Dezember 1999 (1999-12-14)
• PATENT ABSTRACTS OF JAPAN vol. 1999, no. 02, 26. Februar 1999 (1999-02-26) -& JP 10 303464 A (CITIZEN ELECTRON CO), 13. November 1998 (1998-11-13)
• PATENT ABSTRACTS OF JAPAN vol. 2000, no. 03, 30. März 2000 (2000-03-30) -& JP 11 346006 A (ROHM CO LTD), 14. Dezember 1999 (1999-12-14)
• PATENT ABSTRACTS OF JAPAN vol. 1995, no. 11, 26. Dezember 1995 (1995-12-26) -& JP 07 202271 A (MATSUSHITA ELECTRIC), 4. August 1995 (1995-08-04)

EP 1 378 013 B1

## Beschreibung

Die Erfindung betrifft ein Gehäuse für ein strahlungsemittierendes Bauelement, ein strahlungsemittierendes Bauelement mit dem Gehäuse sowie ein Verfahren zur Herstellung des strahlungsemittierenden Bauelements.

Leiterrahmen für strahlungsemittierende Halbleiterbauelemente sind beispielsweise aus DE 195 36 454 bekannt. Die hierin beschriebenen Halbleiterbauelemente weisen einen Gehäusegrundkörper mit darin eingebettetem Leiterrahmen sowie einen strahlungsemittierenden Halbleiterkörper auf, der auf den Leiterrahmen montiert ist. Der Leiterrahmen und der Gehäusegrundkörper sind zugleich als Reflektor für die erzeugte Strahlung ausgebildet.

Weiterhin sind aus dem Gehäusegrundkörper ragende Teilbereiche des Leiterrahmens als externe elektrische Anschlußstreifen gebildet und ist das Gehäuse so geformt, daß das Bauelement zur Oberflächenmontage geeignet ist. Um eine gute Ableitung der entstehenden Verlustwärme, insbesondere bei Halbleiterbauelementen mit hoher Leistung, zu erreichen, kann ein Teil des Reflektors als thermischer Anschluß aus dem Gehäusegrundkörper herausgeführt sein.

Bei Bauelementen mit hohen optischen Leistungen und entsprechend großen Verlustleistungen ist eine noch effizientere Art der Wärmeableitung wünschenswert beziehungsweise erforderlich.

Die Druckschriften DE 4017697 A1, EP 1139439 A1 (Dokument gemäß Art, 54(3) EPÜ), WO 98/20718 A1, DE 19945675 A1 und WO 00/55914 A1 offenbaren Halbleiterbauelemente oder strahlungsemittierende Halbleiterbauelemente, bei denen der Leiterrahmen eine Wärmesenke aufweist.

Aufgabe der vorliegenden Erfindung ist es, bei strahlungsemittierenden Bauelementen eine verbesserte Wärmeableitung zu schaffen, die insbesondere die Erzeugung hoher optischer Leistungen im Bauelement zuläßt. Außerdem sollen eine hohe Strahlungsausbeute und eine zuverlässige elektrische Kontaktierung erzielt werden. Weiterhin ist es Aufgabe der Erfindung, ein Herstellungsverfahren hierfür anzugeben.

Diese Aufgabe wird durch ein Gehäuse gemäß Patentanspruch 1, ein strahlungsemittierendes Bauelement gemäß Patentanspruch 11 beziehungsweise ein Verfahren gemäß Patentanspruch 20 gelöst. Vorteilhafte Weiterbildungen der Erfindung sind Gegenstand der abhängigen Ansprüche.

Das Gehäuse für ein strahlungsemittierendes Bauelement weist einen Leiterrahmen auf, der mindestens einen Chipmontagebereich, mindestens einen Drahtanschlußbereich und mindestens einen externen elektrischen Anschlußstreifen aufweist. Der Leiterrahmen weist ein Trägerteil auf, das den Drahtanschlußbereich, den Anschlußstreifen und eine Einlegeöffnung aufweist, wobei ein separat gefertigtes thermisches Anschlußteil in die Einlegeöffnung eingesetzt und umfangseitig mit dem Trägerteil verbunden ist, und wobei das thermische Anschlussteil den Chipmontagebereich aufweist. Das Gehäuse weist einen Gehäusegrundkörper auf, der aus einer Formmasse gebildet ist und in den der Leiterrahmen derart eingebettet ist, daß der elektrische Anschlußstreifen aus dem Gehäusegrundkörper herausgeführt ist und eine thermische Anschlußfläche des thermischen Anschlußteiles von außen thermisch anschließbar ist. Der Gehäusegrundkörper weist ein Strahlungsaustrittsfenster auf, wobei das thermische Anschlußteil derart in den Gehäusegrundkörper eingebettet ist, daß der Chipmontagebereich im Strahlungsaustrittsfenster angeordnet ist. Die Seitenwände des Strahlungsaustrittsfensters sind als Reflektorflächen geformt, wobei das Strahlungsaustrittsfenster in Richtung des Drahtanschlußbereichs erweitert ist und den Drahtanschlußbereich umfasst, wobei der Drahtanschlußbereich gegenüber dem Chipmontagebereich von diesem aus gesehen erhöht angeordnet ist.

Es ist vorgesehen, ein Gehäuse mit einem Leiterrahmen für ein strahlungsemittierendes Bauelement, bevorzugt eine Lichtemissionsdiode, mit mindestens einem Chipmontagebereich, mindestens einem Drahtanschlußbereich und mindestens einem externen elektrischen Anschlußstreifen, beispielsweise zum Montieren und elektrischen Anschließen des Bauelements auf einer Leiterplatte, auszubilden, wobei ein Trägerteil vorgesehen ist, das den Drahtanschlußbereich und den elektrischen Anschlußstreifen aufweist und in das ein getrennt vom übrigen Leiterrahmen separat gefertigtes thermisches Anschlußteil eingeknüpft ist, auf dem der Chipmontagebereich angeordnet ist. Bei einem Bauelement mit einem derartigen Leiterrahmen wird die im Betrieb entstehende Verlustwärme vor allem über das thermische Anschlußteil abgeführt. Vorzugsweise ist das thermische Anschlußteil mit dem Trägerteil elektrisch leitend verbunden und dient gleichzeitig als elektrischer Anschluß für den Chip.

Das separat von dem übrigen Leiterrahmen gefertigte thermische Anschlußteil weist dabei den Vorteil auf, daß es wesentlich besser hinsichtlich Aufnahme und Ableitung größerer Verlustwärmemengen optimiert werden kann als ein einstückiger Leiterrahmen. So kann bei einem solchen thermischen Anschlußteil die Dicke, die Wärmeleitfähigkeit, der thermische Ausdehnungskoeffizient und die thermische Anschlußfläche weitestgehend unabhängig von den Anforderungen an den übrigen Leiterrahmen optimiert werden. Insbesondere kann bei dem thermischen Anschlußteil vorteilhafterweise eine hohe Wärmekapazität erreicht werden, so daß das thermische Anschlußteil eine effiziente Wärmesenke bildet. Eine große thermische Anschlußfläche verringert den Wärmeübergangswiderstand und verbessert so die Wärmeleitung und die Wärmeabgabe an die Umgebung.

Bei dem Leiterrahmen weist das Trägerteil eine Einlegeöffnung, beispielsweise in Form einer Klammer oder Öse, auf, in die das thermische Anschlußteil eingeknüpft ist. Hierunter ist zu verstehen, daß das thermische Anschlußteil in die Einlegeöffnung des Leiterrahmens eingesetzt und umfangsseitig mit dem Leiterrahmen verbunden ist.

Dazu kann das thermische Anschlußteil in das Trägerteil beispielsweise geklammert und/oder mit diesem verquetscht oder vernietet sein. Bevorzugt wird bei der Erfindung eine Quetschverbindung zwischen dem thermischen Anschlußteil und dem Trägerteil gebildet, die sich durch hohe mechanische Festigkeit und gute elektrische Leitfähigkeit auszeichnet. Eine Quetsch-verbindung kann beispielsweise dadurch gebildet werden, daß das Trägerteil und das thermische Anschlußteil zueinander positioniert werden, beispielsweise durch Einlegen des Anschlußteils in eine Einlegeöffnung des Trägerteils, und dann das thermische Anschlußteil derart verformt wird, daß ein mechanisch fester Sitz des Anschlußteils im Trägerteil entsteht. Zur Verformung kann ein hammer- oder stempelartiges Werkzeug verwendet werden.

Bevorzugt ist das Anschlußteil so geformt, daß es nach Art einer Niete mit dem Trägerteil verbunden werden kann. Gegebenenfalls genügt auch die Verformung einzelner Stege oder Streben des Anschlußteils, um eine Quetschverbindung ausreichender Festigkeit zwischen dem Anschlußteil und dem Trägerteil zu bilden.

Im Rahmen der Erfindung können zusätzlich oder alternativ anderweitige Verbindungen zwischen dem Anschlußteil und dem Trägerteil vorgesehen sein. Beispielsweise ist eine Löt- oder Schweißverbindung hierfür geeignet. Weiterhin kann das Anschlußteil mit dem Trägerteil verklebt sein.

Mit Vorteil wird so ein mechanisch stabiles Gerüst für das Halbleiterbauelement gebildet, das mit vergleichsweise geringem technischem Aufwand herstellbar ist.

Bevorzugt weist das thermische Anschlußteil eine Reflektorwanne auf. Bei einem damit gebildeten Bauelement verbessert das thermische Anschlußteil die Strahlungsausbeute und die Strahlbündelung des Bauelements. Bei dieser Weiterbildung der Erfindung wird vorzugsweise ein metallisches thermisches Anschlußteil verwendet, da sich Metallflächen aufgrund geringer Absorptionsverluste und einer stark gerichteten, gegebenenfalls spiegelnden Reflexion sehr gut als Reflektorflächen eignen.

Zur Erhöhung der mechanischen Stabilität, insbesondere bei einem im folgenden noch genauer erläuterten Gehäuse bzw. Bauelement, ist es vorteilhaft, die Höhe der Reflektorwanne des thermische Anschlußteils so zu bemessen, daß sie die doppelte Höhe des zur Anordnung auf dem Chipmontagebereich vorgesehenen Chips nicht übersteigt.

Als Material für das thermische Anschlußteil eignen sich aufgrund der hohen Wärmeleitfähigkeit Metalle, insbesondere Kupfer oder Aluminium oder hieraus gebildete Legierungen. Weiterhin bevorzugte Materialen sind Molybdän, Eisen, Nickel und Wolfram sowie Nickel-Eisen- und Kupfer-Wolfram-Legierungen, deren thermischer Ausdehnungskoeffient gut an den thermischen Ausdehnungskoeffienten von Halbleitermaterialien wie beispielsweise GaAs, GaN und darauf basierenden Systemen, angepaßt ist. Weiter eignen sich als Material für das thermische Anschlußteil Keramiken und Halbleiter wie beispielsweise Silizium. Das thermische Anschlußteil kann auch mehrlagig, beispielsweise als Metall-Keramik-Verbundsystem gebildet sein.

Bevorzugt ist die Chipmontagefläche des thermischen Anschlußteils mit einer Vergütung versehen, die die Oberflächeneigenschaften hinsichtlich der Aufbringung eines Chips (Bondeigenschaften) verbessert. Diese Vergütung kann beispielsweise eine Silber- oder Goldbeschichtung umfassen.

Weitergehend ist es vorteilhaft, auch den Lötanschlußsteifen bzw. den Bonddrahtanschlußbereich mit einer die Löt- bzw. Bondeigenschaften verbessernden Oberflächenvergütung, beispielsweise einer Au-, Ag- Sn- oder Zn-Beschichtung, zu versehen.

Das Trägerteil enthält vorzugsweise Kupfer oder Weicheisen und kann beispielsweise aus entsprechenden Folien gestanzt werden. Mit Vorteil dient das Trägerteil bei der Erfindung nicht der Wärmeableitung und kann daher für die Funktion der Stromversorgung sowie hinsichtlich seiner Biegeeigenschaften und Haftung einer im folgenden noch genauer beschriebenen Formmasse optimiert werden.

Dies umfaßt beispielsweise, daß das Trägerteil in seiner Dicke so ausgeführt ist, daß es aus einem Trägerband von der Rolle gefertigt, leicht gestanzt und in Form gebogen werden kann. Derartige Verarbeitungseigenschaften erlauben mit Vorteil eine automatisierte Fertigung und eine dichte Anordnung (geringer Pitch) der Einzelkomponenten auf dem Trägerband.

Die hierfür erforderliche geringe Dicke des Trägerteils erschwert in der Regel eine ausreichende Kühlung des Chips. Insbesondere ist aus Gründen der mechanischen Stabilität der Querschnitt eines thermischen Anschlusses begrenzt. Dieser Nachteil wird bei der Erfindung durch das eingeknüpfte thermische Anschlußteil behoben.

Zur Ausbildung des Gehäuses für ein strahlungsemittierendes Bauelement ist der Leiterrahmen von einem Gehäusegrundkörper umschlossen. Dazu ist der Leiterrahmen in eine den Gehäusegrundkörper bildende Formmasse, beispielsweise eine Spritzguß- oder Spritzpreßmasse eingebettet. Dies erlaubt eine kostengünstige Herstellung des Gehäuses im Spritzguß oder Spritzpressgußverfahren. Die Formmasse besteht beispielsweise aus einem Kunststoffmaterial auf der Basis von Epoxidharz oder Acrylharz, kann aber auch aus jedem anderen für den vorliegenden Zweck geeigneten Material bestehen. Zur Wärmeableitung ist es vorteilhaft, das thermische Anschlußteil so einzubetten, daß es teilweise aus dem Gehäusegrundkörper ragt oder einen Teil von dessen Oberfläche bildet und somit von außen thermisch anschließbar ist.

In dem Gehäusegrundkörper ist eine Ausnehmung in Form eines Strahlungstrittsfensters gebildet und das thermische Anschlußteil derart in den Gehäusegrundkörper eingebettet, daß der Chipmontagebereich innerhalb des Strahlungsaustrittsfensters angeordnet ist. Beispielsweise kann der Chipmontagebereich eine Begrenzungsfläche des Strahlungsaustrittsfensters bilden.

Diese Gehäuseform eignet sich insbesondere für oberflächenmontierbare Bauelemente, wobei die dem Strahlungsaustrittsfenster gegenüberliegenden Seite oder eine Seitenfläche des Gehäusegrundkörpers eine Auflagefläche des Bauelements bildet. Bevorzugt erstreckt sich das eingebettete thermische Anschlußteil bis zu dieser Auflagefläche, so daß über die Auflagefläche zugleich die Verlustwärme, beispielsweise an einen Kühlkörper oder ein PCB (printed circuit board, Leiterplatte) abgeführt wird. Dabei ist es vorteilhaft, das thermische Anschlußteil so auszuführen, daß ein Teil seiner Oberfläche zugleich die Auflagefläche oder eine Teilfläche hiervon bildet.

Zur Steigerung der Strahlungsausbeute kann das Strahlungsaustrittsfenster in dem Gehäusegrundkörper konisch geformt sein, so daß dessen Seitenwände einen Reflektor bilden. Durch diesen Reflektor können von einer auf dem Chipmontagebereich befindlichen Strahlungsquelle zur Seite emittierte Strahlungsanteile zur Hauptabstrahlungsrichtung hin umgelenkt werden. Damit wird eine Erhöhung der Strahlungsausbeute und eine verbesserte Bündelung der Strahlung erreicht.

Vorteilhaft ist bei dem Reflektor eine Formgebung, bei der das thermische Anschlußteil einen ersten Teilbereich des Reflektors bildet, an den sich ein zweiter, von den Seitenwänden des Strahlungsaustrittsfensters geformter Reflektorteilbereich anschließt. Bevorzugt ist die Gesamthöhe des Reflektors geringer als die vierfache Höhe eines zur Befestigung auf dem Chipmontagebereich vorgesehenen Chips. Dies gewährleistet eine hohe mechanische Stabilität und limitiert die aufgrund von Temperaturänderungen auftretenden Spannungen, wie sie beispielsweise bei Lötprozessen entstehen, auf ein tolerables Maß.

Bei der Erfindung ist weiter vorgesehen, mit einem erfindungsgemäßen Gehäuse ein strahlungsemittierendes Bauelement mit verbesserter Wärmeableitung zu bilden. Ein solches Bauelement weist einen strahlungsemittierenden Chip, vorzugsweise einen Halbleiterchip, auf, der auf dem Chipmontagebereich des thermischen Anschlußteils angeordnet ist.

Bevorzugt ist der Chip zumindest teilweise von einer Vergußmasse umhüllt. Besonders bevorzugt ist diese Ausführungsform für Gehäuse mit einem in einem Strahlungsaustrittsfenster angeordneten Chip, wobei das Strahlungsaustrittsfenster ganz oder teilweise mit der Vergussemasse gefüllt ist. Als Verguß eignen sich insbesondere Reaktionsharze wie beispielsweise Epoxidharze, Acrylharze oder Siliconharze oder Mischungen hiervon. Weitergehend können dem Verguß Leuchtstoffe zugesetzt sein, die die von dem Chip erzeugte Strahlung in einen anderen Wellenlängenbereich konvertieren. Diese Ausführungsform eignet sich insbesondere für mischfarbiges oder weißes Licht abstrahlende Bauelement.

Um thermische Verspannungen zwischen Gehäuse, Chip und Verguß gering zu halten und insbesondere eine Delamination der Vergußabdeckung zu vermeiden, ist es vorteilhaft, das Vergußvolumen V so zu wählen, daß bezüglich der Höhe H des Chips die Relation

$$V \le q \cdot H$$

erfüllt ist. Dabei bezeichnet q einen Skalierungsfaktor, dessen Wert kleiner als 10 mm$^2$ ist und vorzugsweise 7 mm$^2$ beträgt.

Bei einer vorteilhaften Weiterbildung der Erfindung ist der Leiterrahmen in ein erstes und ein zweites elektrisches Anschlußteil gegliedert, wobei das thermische Anschlußteil in das erste elektrische Anschlußteil eingeknüpft und der Bonddrahtanschlußbereich auf dem zweiten elektrischen Anschlußteil ausgebildet ist. Zur elektrischen Versorgung ist von einer Kontaktfläche des Chips eine Drahtverbindung zu dem Bonddrahtanschlußbereich geführt.

Ein Verfahren zur Herstellung eines erfindungsgemäßen Bauelements beginnt mit der Bereitstellung eines Trägerteiles, das beispielsweise zuvor aus einem Band oder einer Folie gestanzt wurde.

Im nächsten Schritt wird ein separat gefertigtes thermisches Anschlußteil in eine dafür vorgesehene Öffnung des Trägerteils eingeknüpft. Nachfolgend wird der Chip auf das thermische Anschlußteil montiert, beispielsweise durch Aufkleben mittels eines elektrisch leitfähigen Haftmittels oder durch Auflöten. Abschließend wird der so gebildete Leiterrahmen mit einer geeigneten Gehäuseformmasse zur Ausbildung des Gehäuses umhüllt, beispielsweise in einem Spritzguß- oder Spritzpreßverfahren.

Die Montage des Chips auf den Leiterrahmen vor dem Umspritzen hat den Vorteil, daß hierfür auch Hochtemperaturverfahren, beispielsweise Lötverfahren, angewendet werden können. Angespritzte Gehäuseteile könnten bei derartigen Temperaturen beschädigt werden. Falls dies nicht relevant ist, können die Verfahrensschritte selbstverständlich auch in anderer Reihenfolge durchgeführt werden.

Bei einer Montage des Chips auf den Leiterrahmen vor dem Umspritzen kann der Chip insbesondere bei Temperaturen über 260°C mittels eines Hartlötverfahrens aufgebracht werden. Damit wird ein besonders niedriger Wärmewiderstand zwischen Chip und Leiterrahmen erreicht. Zudem wird eine sehr temperaturbeständige Verbindung zwischen Chip und thermischem Anschlußteil geschaffen und insbesondere beim Einlöten des Bauelements bei typischen Temperaturen bis etwa 260°C die Gefahr einer Ablösung des Chips verringert.

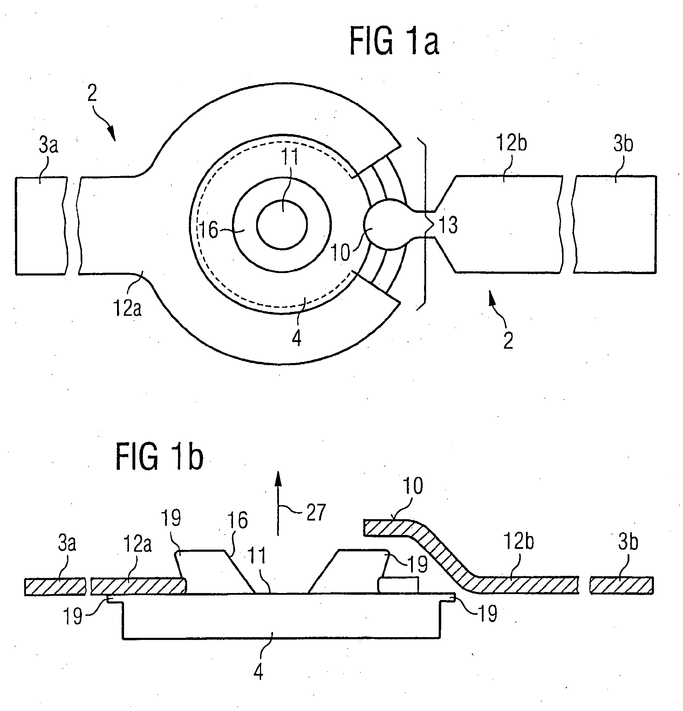

Weitere Merkmale, Vorzüge und Zweckmäßigkeiten der Erfindung werden nachfolgend in Verbindung mit den Figuren 1 bis 5 erläutert.

Es zeigen

| | |
|---|---|
| Figur 1a und 1b | eine schematische Aufsicht bzw. Schnittansicht eines Leiterrahmens, |
| Figur 2 | eine schematische, perspektivische Schnittansicht eines ersten Ausführungsbeispiels eines erfindungsgemäßen Gehäuses, |
| Figur 3 | eine schematische, perspektivische Ansicht eines zweiten Ausführungsbeispiels eines erfindungsgemäßen Gehäuses, |
| Figur 4 | eine schematische, perspektivische Ansicht eines ersten Ausführungsbeispiels eines erfindungsgemäßen Bauelements und |
| Figur 5 | einen schematischen Querschnitt eines zweiten Ausführungsbeispiels eines erfindungsgemäßen Bauelements. |

Der in Figur 1a und 1b dargestellte Leiterrahmen 2 umfaßt ein in zwei elektrische Anschlußteile 12a,b gegliedertes Trägerteil sowie ein thermisches Anschlußteil 4. Die beiden elektrischen Anschlußteile 12a,b enden jeweils in einem Lötanschlußstreifen 3a,b.

Das eine elektrische Anschlußteil 12a weist eine Öffnung in Form einer Öse auf. In die Ösenöffnung ist das thermische Anschlußteil 4 eingeknüpft. Dazu kann beispielsweise das thermische Anschlußteil 4 paßgenau in die Ösenöffnung des elektrischen Anschlußteils 12a eingelegt und nachfolgend nach Art einer Niete mit dem elektrischen Anschlußteil 12a verquetscht werden. Alternative umfangsseitige Verbindungen zwischen dem thermischen 4 und dem elektrischen Anschlußteil 12a, beispielsweise durch Vernieten, Verlöten oder Verschweißen, sind ebenfalls möglich.

Das thermische Anschlußteil 4 ist im wesentlichen rotationssymmetisch und weist Vorsprünge 19 auf, die eine stabile Verankerung des Leiterrahmens 2 in einem Gehäuse ermöglichen. Weiterhin ist in dem thermischen Anschlußteil 4 eine zentrische Einsenkung in Form einer Reflektorwanne 16 gebildet, auf deren Bodenfläche ein Chipmontagebereich 11 zur Aufnahme eines strahlungsemittierenden Chips vorgesehen ist. Die Seitenflächen der Einsenkung dienen als Reflektorflächen.

Der Ösenring des elektrischen Anschlußteils 12a weist eine Aussparung 13 auf, mit der ein zungenförmig gestalteter Bonddrahtanschlußbereich 10 des zweiten elektrischen Anschlußteils 12b überlappt. Dieser Bonddrahtanschlußbereich 10 ist höhenversetzt zu dem abstrahlungsseitigen Rand der Reflektorwanne angeordnet. Dies ermöglicht bei der Chipmontage kurze Drahtverbindungen zwischen Chip und Bonddrahtanschlußbereich 10, ohne daß hierfür eine Aussparung am Rand der Reflektorwanne in dem thermischen Anschlußteil erforderlich ist.

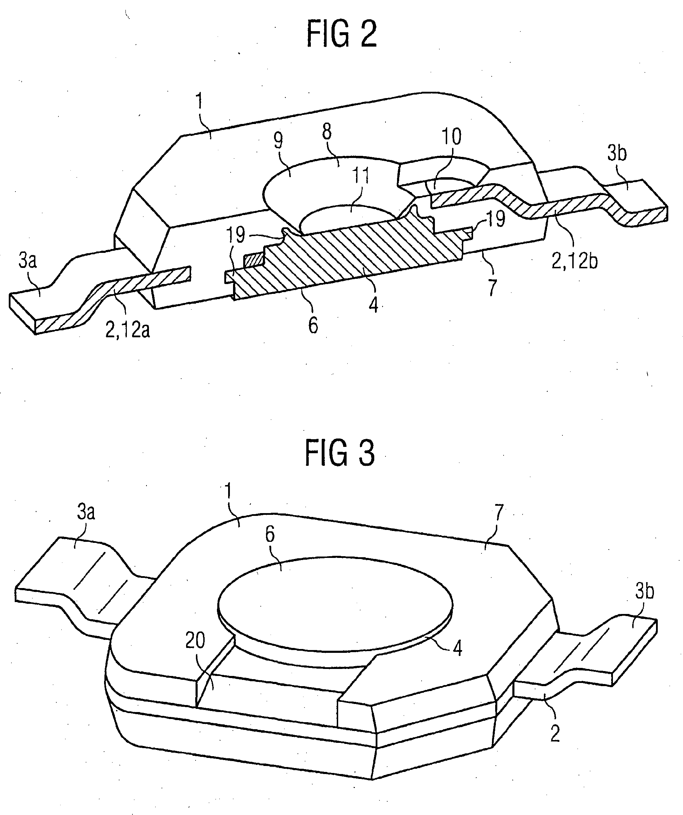

In Figur 2 ist perspektivisch ein Längsschnitt durch ein Ausführungsbeispiel eines erfindungsgemäßen Gehäuses dargestellt. Das Gehäuse weist einen Grundkörper 1 aus Kunststoff-Formmasse auf, der beispielsweise mittels eines Spritzguß oder Spritzpreßverfahrens hergestellt sein kann. Die Formmasse besteht beispielsweise aus einem Kunststoffmaterial auf der Basis von Epoxidharz oder Acrylharz, kann aber auch aus jedem anderen für den vorliegenden Zweck geeigneten Material bestehen.

In den Grundkörper 1 ist ein im wesentlichen Figur 1 entsprechender Leiterrahmen 2 mit zwei elektrischen Anschlußteilen 12a,b und einem darin eingeknüpften thermischen Anschlußteil 4 sowie Lötanschlußstreifen eingebettet, wobei letztere aus dem Gehäusegrundkörper herausragen. Auf der Seite des Chipanschlußbereichs 11 ist das thermische Anschlußteil 4 weitgehend plan ohne Reflektorwanne ausgebildet.

Das thermische Anschlußteil 4 ist dabei so innerhalb des Gehäusegrundkörpers 1 angeordnet, daß die Bodenfläche 6 des thermischen Anschlußteils 4 einen Teil der Grundkörperauflagefläche 7 bildet. Zur mechanisch stabilen Verankerung in dem Gehäusegrundkörper ist das thermische Anschlußteil mit umfangsseitig angeordneten Vorsprüngen 19 versehen.

Der Auflagefläche 7 gegenüberliegend ist als Strahlungsaustrittsfenster eine Ausnehmung 8 in dem Gehäusegrundkörper geformt, die zu dem Chipmontagebereich 11 auf dem thermischen Anschlußteil 4 führt, so daß ein darauf zu befestigender strahlungsemittierender Chip sich innerhalb des Strahlungsaustrittsfensters 8 befindet. Die Seitenflächen 9 des Strahlungsaustrittsfensters 8 sind angeschrägt und dienen als Reflektor für die von einem solchen Chip im Betrieb erzeugte Strahlung.

Figur 3 zeigt eine perspektivische Ansicht auf die Auflagefläche eines weiteren Ausführungsbeispiels eines erfindungsgemäßen Gehäuses. Wie bei dem zuvor beschriebenen Ausführungsbeispiel ist die Bodenfläche 6 des thermischen Anschlußteils 4 aus dem Gehäusegrundkörper 1 herausgeführt. Dabei ragt die Bodenfläche 6 des thermischen Anschlußteils 4 etwas aus dem Grundkörpers 1 hervor, so daß im eingebauten Zustand eine sichere Auflage und eine guter Wärmeübergang zwischen dem thermischen Anschlußteil 4 und einem entsprechenden Träger wie beispielsweise einer Leiterplatte oder einem Kühlkörper gewährleistet ist.

Im Unterschied zu dem zuvor beschriebenen Ausführungsbeispiel weist der Gehäusegrundkörper 1 eine seitliche, von dem thermischen Anschlußteil 4 zu einer Seitenfläche des Gehäusegrundkörpers 1 verlaufende Nut 20 auf. Ist das Gehäuse auf einen Träger montiert, so erlaubt diese Nut 20 auch im eingebauten Zustand eine Kontrolle der Verbindung zwischen dem Gehäuse und dem Träger. Insbesondere kann damit eine Lötverbindung zwischen dem Träger und dem thermischem Anschlußteil überprüft werden.

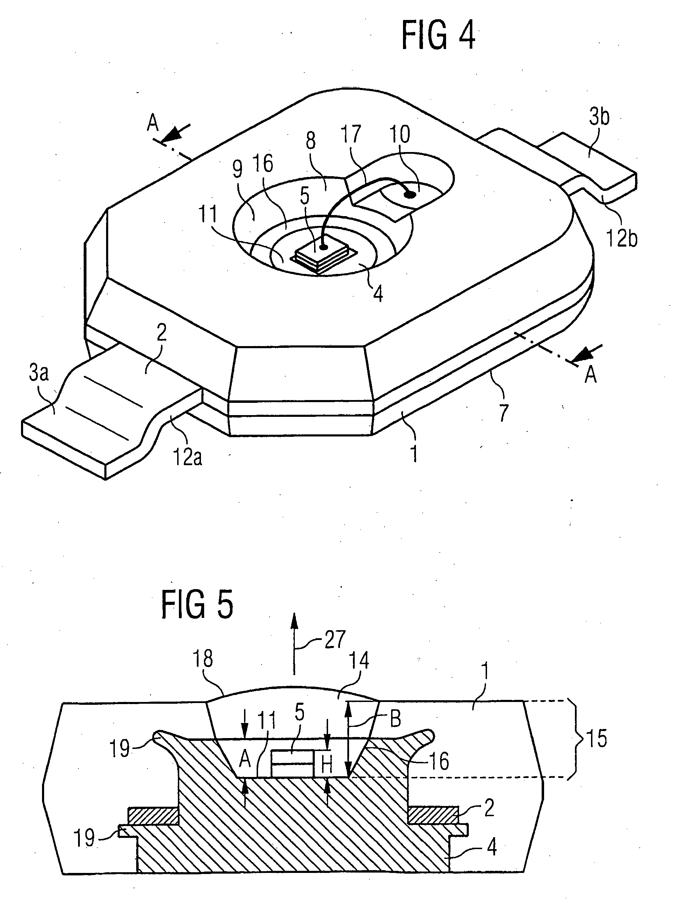

In Figur 4 ist eine schematische, perspektivische Ansicht eines Ausführungsbeispiels eines erfindungsgemäßen strahlungsemittierenden Bauelements gezeigt.

Wie bei dem zuvor beschriebenen Ausführungsbeispiel ist ein Leiterrahmen 2 mit einem eingeknüpften thermische Anschlußteil 4 weitgehend in den Gehäusegrundkörper 1 eingebettet, so daß lediglich die Lötanschlußstreifen 3a,b seitlich aus dem Gehäusegrundkörper 1 herausragen. Das thermische Anschlußteil 4 bildet in nicht dargestellter Weise einen Teil der Auflagefläche 7 des Gehäusegrundkörpers bildet und ist so von außen thermisch anschließbar.

Auf dem Chipmontagebereich 11 des thermischen Anschlußteils 4 ist ein strahlungsemittierender Chip 5 wie zum Beispiel eine Lichtemissionsdiode befestigt. Vorzugsweise ist dies ein Halbleiterchip, beispielsweise ein LED-Chip oder ein Laserchip, der mittels eines Hartlots auf das thermische Anschlußteil 4 aufgelötet ist. Alternativ kann der Chip mit einem Haftmittel, das eine ausreichende Wärmeleitfähigkeit aufweist und vorzugsweise auch elektrisch leitfähig ist, auf dem Chipmontagebereich 11 aufgeklebt sein.

Für effiziente Strahlungsquellen eignen sich insbesondere Halbleitermaterialien auf der Basis von GaAs, GaP und GaN wie beispielsweise GaAlAs, InGaAs, InGaAlAs, InGaAlP, GaN, GaAlN, InGaN und InGaAlN.

Das Gehäuse des Bauelements entspricht im wesentlichen dem in Figur 2 beziehungsweise 3 dargestellten Gehäuse. Im Unterschied hierzu weist das thermische Anschlußteil 4 eine den Chip 5 umgebende Reflektorwanne 16 auf. Deren Reflektorflächen gehen im wesentlichen nahtlos in die Seitenflächen 9 des Strahlungsaustrittsfensters 8 über, so daß ein Gesamtreflektor entsteht, der sich aus einem von dem thermischen Anschlußteil 4 gebildeten Teilbereich und einem von den Seitenflächen 9 des Strahlungsaustrittsfensters 8 gebildeten Teilbereich zusammensetzt.

Weiterhin ist das Strahlungsaustrittsfenster 8 in der Längsrichtung des Bauelements etwas erweitert und umfaßt einen Bonddrahtanschlußbereich 10 auf dem nicht mit dem thermischen Anschlußteil verbundenen elektrischen Anschlußteil 12b des Leiterrahmens 2. Von diesem Bonddrahtanschlußbereich 10 ist eine Drahtverbindung 17 zu einer auf dem Chip 5 aufgebrachten Kontaktfläche geführt.

Der Bonddrahtanschlußbereich 10 ist höhenversetzt zum abstrahlungsseitigen Rand der Reflektorwanne 16 des thermischen Anschlußteils angeordnet. Dies ermöglicht eine kurze und damit mechanisch stabile Drahtverbindung zwischen Chip 5 und Bonddrahtanschlußbereich 10, da letzterer nahe an den Chip 5 herangeführt werden kann. Weiterhin wird dadurch die Höhe des entstehenden Drahtbogens gering gehalten und so die Gefahr eines Kurzschlusses, der beispielsweise bei einer Abdeckung des Chips mit einem Verguß durch seitliches Umklappen der Drahtverbindung auf das thermische Anschlußteil entstehen könnte, reduziert.

In Figur 5 ist der Querschnitt eines weiteren Ausführungsbeispiels eines erfindungsgemäßen Bauelements dargestellt. Der Schnittverlauf entspricht der in Figur 4 eingezeichneten Linie A-A.

Wie bei dem in Figur 3 gezeigten Ausführungsbeispiel ist das thermische Anschlußteil auf der Montageseite für den Chip 5 mittig eingesenkt, so dass eine Reflektorwanne 16 für die von dem Chip 5 erzeugte Strahlung entsteht, an die sich die Reflektorseitenwände 9 des Strahlungsaustrittsfensters 8 anschließen.

Im Unterschied zu dem vorigen Ausführungsbeispiel weist der so gebildete Gesamtreflektor 15 an der Übergangsstelle zwischen den Teilreflektoren 9,16 einen Knick auf. Durch diese Formgebung wird eine verbesserte Annäherung des Gesamtreflektors 15 an ein Rotationsparaboloid und somit eine vorteilhafte Abstrahlcharakteristik erreicht. Das vom Chip in einem steileren Winkel zur Bodenfläche der Wanne abgestrahlte Licht wird stärker zur Hauptabstrahlrichtung 27 des Bauelements hin umgelenkt.

Zum Schutz des Chips ist das Strahlungsaustrittsfenster 8 mit einem Verguß 14, beispielsweise ein Reaktionsharz wie Epoxidharz oder Acrylharz, gefüllt. Zur Bündelung der erzeugten Strahlung kann der Verguß 14 nach Art einer Linse mit einer leicht gewölbten Oberfläche 18 geformt sein.

Um eine mechanisch stabile Verbindung von Verguß 14, Gehäusegrundkörper 1 und Leiterrahmen 2 zu erzielen, ist es vorteilhaft, die Höhe A der Reflektorwanne 16 des thermischen Anschlußteils geringer als die doppelte Höhe H des Chips 5 zu wählen. Die Höhe B des gesamten von dem thermischen Anschlußteil 4 und dem Gehäusegrundkörper 1 gebildeten Reflektors 15 sollte kleiner als die vierfache Höhe H des Chips 5 sein. Schließlich ist es vorteilhaft, das Strahlungsaustrittsfenster 8 so zu formen, daß für das Volumen V des Vergussen die obengenannte Relation

$$V \leq q \cdot H$$

erfüllt ist, wobei q etwa 7mm[2] beträgt. Durch Erfüllung dieser Maßgaben wird die mechanische Stabilität und damit die Belastbarkeit und Lebensdauer des Bauelements vorteilhaft erhöht. Die Verankerung des thermischen Anschlußteils 4 mittels der Vorsprünge 19 in dem Gehäusegrundkörper 1 trägt ebenfalls hierzu bei.

Zur Herstellung eines solchen Bauelements wird zunächst für den Leiterrahmen 2 ein Trägerteil, das beispielsweise aus einem Trägerband ausgestanzt wird, mit einer Öffnung bereitgestellt. Nachfolgend wird das thermische Anschlußteil 4 in die Öffnung des Trägerteils eingesetzt und mit dem Trägerteil verquetscht.

Im nächsten Schritt wird auf dem thermischen Anschlußteil 4 der strahlungsemittierende Chip 5 aufgebracht, beispielsweise aufgelötet oder aufgeklebt. Zur Ausbildung des Gehäusegrundkörpers 1 wird der aus dem Trägerteil und dem thermischen Anschlußteil 4 gebildete Leiterrahmen 2 mit dem vormontierten Chip 5 von einer Formmasse umhüllt, wobei der den Chip 5 umgebende Bereich sowie der Bonddrahtanschlußbereich 10 ausgespart wird. Dies kann beispielsweise in einem Spritzguß- oder Spritzpreßverfahren erfolgen. Von dem Bonddrahtanschlußbereich 10 wird abschließend eine Drahtverbindung 17 zu einer Kontaktfläche des Chips 5 geführt.

Alternativ kann nach der Verbindung von Trägerteil und thermischem Anschlußteil 4 der so gebildete Leiterrahmen 2 zuerst von der Formmasse umhüllt und der Chip 5 danach auf dem Chipanschlußbereich 11 befestigt, vorzugsweise aufgeklebt, und kontaktiert werden.

Das oben beschriebene Verfahren, umfassend die Schritte Bereitstellen eines Leiterrahmens und Aufbringen des Chip, vorzugsweise durch Auflöten, vor einer Umhüllung des Leiterrahmens mit einer Formmasse, wobei die Umgebung des Chips ausgespart bleibt, hat die Vorteile, daß die Befestigung des Chips weitgehend unabhängig von den Eigenschaften der Formmasse optimiert werden kann. Ein Lötprozeß kann beispielsweise in einem erweiterten Temperaturbereich stattfinden. Dabei können Lote, vorzugsweise mit einer Schmelztemperatur über 260° C wie beispielsweise Hartlote, verwendet werden, die eine Verbindung mit sehr geringem Wärmewiderstand zwischen Chip und Leiterrahmen ausbilden. Weiterhin wird damit die Gefahr verringert, daß sich beim Auflöten eines entsprechenden Bauelements auf eine Leiterplatte der Chip ablösen könnte.

**Patentansprüche**

1. Gehäuse (2) für ein strahlungsemittierendes Bauelement mit einem Leiterrahmen, der mindestens einen Chipmontagebereich (11), mindestens einen Drahtanschlußbereich (10) und mindestens einen externen elektrischen Anschlußstreifen (3a,b) aufweist, wobei

    - der Leiterrahmen ein Trägerteil aufweist, das den Drahtanschlußbereich (10), den Anschlußstreifen (3a,b) und eine Einlegeöffnung aufweist,
    - ein separat gefertigtes thermisches Anschlußteil (4) in die Einlegeöffnung eingesetzt und umfangseitig mit dem Trägerteil verbunden ist, wobei das thermische Anschlussteil (4) den Chipmontagebereich (11) aufweist,
    - das Gehäuse (1) einen Gehäusegrundkörper (1) aufweist, der aus einer Formmasse gebildet ist und in den der Leiterrahmen (2) derart eingebettet ist, daß der elektrische Anschlußstreifen (3a,b) aus dem Gehäusegrundkörper herausgeführt ist und eine thermische Anschlußfläche des thermischen Anschlußteiles (4) von außen thermisch anschließbar ist,
    - der Gehäusegrundkörper (1) ein Strahlungsaustrittsfenster (8) aufweist und das thermische Anschlußteil (4) derart in den Gehäusegrundkörper eingebettet ist, daß der Chipmontagebereich (11) im Strahlungsaustrittsfenster (8) angeordnet ist,
    **dadurch gekennzeichnet, dass**
    - die Seitenwände (9) des Strahlungsaustrittsfensters (8) als Reflektorflächen geformt sind, wobei das Strahlungsaustrittsfenster (8) in Richtung des Drahtanschlußbereichs (10) erweitert ist und den Drahtanschlußbereich (10) umfasst, und
    - der Drahtanschlußbereich (10) gegenüber dem Chipmontagebereich (11) von diesem aus gesehen erhöht angeordnet ist.

2. Gehäuse (2) nach Anspruch 1,
    **dadurch gekennzeichnet, daß** das Trägerteil eine Klammer oder Öse aufweist, in die das thermische Anschlußteil (4) eingeknüpft ist.

3. Gehäuse (2) nach Anspruch 1 oder 2,
    **dadurch gekennzeichnet, daß** zwischen dem thermischen Anschlußteil (4) und dem Trägerteil eine Quetsch-, Niet-, Löt- oder Schweißverbindung vorgesehen ist.

4. Gehäuse (2) nach einem der Ansprüche 1 bis 3,
    **dadurch gekennzeichnet, daß** das thermische Anschlußteil (4) Cu, Al, Mo, Fe, Ni oder W enthält.

5. Gehäuse (2) nach einem der Ansprüche 1 bis 4,
    **dadurch gekennzeichnet, daß** der Chipmontagebereich (11) mit einer Oberflächenvergütung zur Verbesserung der Chipmontage versehen ist.

6. Gehäuse (2) nach Anspruch 5,
    **dadurch gekennzeichnet, daß** die Oberflächenvergütung für die Chipmontage eine Ag-oder Au-Beschichtung umfaßt.

7. Gehäuse (2) nach einem der Ansprüche 1 bis 6,
    **dadurch gekennzeichnet, daß** der Leiterrahmen (2) Cu oder Fe enthält.

8. Gehäuse (2) nach einem der Ansprüche 1 bis 7,
    **dadurch gekennzeichnet, daß** der externe elektrische Anschlußstreifen (3a,b) eine Oberflächenvergütung zur Verbesserung der Bauelement-Montageeigenschaften aufweist.

9. Gehäuse (2) nach Anspruch 8, **dadurch gekennzeichnet, daß** die Oberflächenvergütung zur Verbesserung der Bauelement-Montageeigenschaften eine Ag-, Au-, Sn- oder Zn-Beschichtung umfaßt.

10. Gehäuse nach einem der vorhergehenden Ansprüche, **dadurch gekennzeichnet, daß** es oberflächenmontierbar ist.

11. Strahlungsemittierendes Bauelement mit einem strahlungsemittierenden Chip (5), **dadurch gekennzeichnet, daß** es ein Gehäuse nach einem der Ansprüche 1 bis 10 aufweist, wobei der Chip (5) auf dem Chipmontagebereich (11) des thermischen Anschlußteils (4) befestigt ist.

12. Strahlungsemittierendes Bauelement nach Anspruch 11, **dadurch gekennzeichnet, daß** der Chip (5) ein Halbleiterchip ist.

13. Strahlungsemittierendes Bauelement nach Anspruch 11 oder 12, **dadurch gekennzeichnet, daß** der Chip (5) zumindest teilweise mit einer strahlungsdurchlässigen Masse (14), insbesondere einer Kunststoffmasse, wie ein Gießharz oder eine Pressmasse umhüllt ist.

14. Strahlungsemittierendes Bauelement nach Anspruch 13, **dadurch gekennzeichnet, daß** die Kunststoffmasse ein Epoxidharz, ein Acrylharz, ein Siliconharz oder eine Mischung dieser Harze enthält.

15. Strahlungsemittierendes Halbleiterbauelement nach Anspruch 13 oder 14, **dadurch gekennzeichnet, daß** für das Volumen (V) der strahlungsdurchlässigen Masse (14) gilt:

$$V \leq q \cdot H,$$

wobei H die Höhe des Chips (5) und q ein Skalierungsfaktor ist, dessen Wert kleiner als 10 mm$^2$ ist und vorzugsweise 7 mm$^2$ beträgt.

16. Strahlungsemittierendes Halbleiterbauelement nach einem der Ansprüche 11 bis 15, **dadurch gekennzeichnet, daß** der Chip (5) auf den Chipmontagebereich (11) aufgeklebt oder aufgelötet ist.

17. Strahlungsemittierendes Halbleiterbauelement nach Anspruch 16, **dadurch gekennzeichnet, daß** der Chip (5) mittels eines Hartlots auf dem Chipmontagebereich (11) befestigt ist.

18. Strahlungsemittierendes Halbleiterbauelement nach Anspruch 17, **dadurch gekennzeichnet, daß** die Schmelztemperatur des Hartlots größer als 260° C ist.

19. Strahlungsemittierendes Halbleiterbauelement nach einem der Ansprüche 11 bis 18, **dadurch gekennzeichnet, daß** der Chip (5) mit dem Drahtanschlußbereich (10) mittels einer Drahtverbindung (17) elektrisch leitend verbunden ist.

20. Verfahren zur Herstellung eines strahlungsemittierenden Halbleiterbauelements nach einem der Ansprüche 11 bis 19, **gekennzeichnet durch** die Schritte

- Bereitstellen eines Trägerteils,
- Einsetzen eines einen Chipmontagebereich (11) aufweisenden thermischen Anschlußteils (4) in eine Einlegeöffnung des Trägerteils,
- Aufbringen eines strahlungsemittierenden Chips (5) auf den Chipmontagebereich (11),
- Einbetten des Trägerteils (2) und des thermischen Anschlußteils (4) in eine Gehäuseformmasse, wobei
- die Seitenwände (9) des Strahlungsaustrittsfensters (8) als Reflektorflächen geformt sind, wobei das Strahlungsaustrittsfenster (8) in Richtung des Drahtanschlußbereichs (10) erweitert ist und den Drahtanschlußbereich (10) umfasst, und
- der Drahtanschlußbereich (10) gegenüber dem Chipmontagebereich (11) von diesem aus gesehen erhöht angeordnet ist.

21. Verfahren nach Anspruch 20, **dadurch gekennzeichnet, daß** das thermische Anschlußteil (4) durch Vernieten, Verquetschen oder Verlöten mit dem Trägerteil verbunden wird.

22. Verfahren nach Anspruch 20 oder 21, **dadurch gekennzeichnet, daß** der Chip (5) vor dem Einbetten des Trägerteils und des thermische Anschlußteils (4) in die Gehäuseformmasse auf den Chipmontagebereich (11) aufgebracht wird.

23. Verfahren nach einem der Ansprüche 20 bis 22, **dadurch gekennzeichnet, daß** der Chip (5) auf den Chipmontagebereich (11) aufgelötet wird, wobei die Löttemperatur größer als 260 °C ist.

24. Verfahren nach Anspruch 23, **dadurch gekennzeichnet, daß** der Chip (5) mittels eines Hartlots auf dem Chipmontagebereich (11) befestigt wird.

**25.** Verfahren nach einem der Ansprüche 20 bis 24, **dadurch gekennzeichnet, daß** das Einbetten des Trägerteils (2) und des thermischen Anschlußteils (4) in eine Gehäuseformmasse mittels eines Spritzguß- oder Spritzpreßverfahrens erfolgt.

**Claims**

**1.** Housing (2) for a radiation-emitting component having a leadframe which has at least one chip mounting area (11), at least one wire connecting area (10) and at least one external electrical connecting strip (3a, b), wherein

- the leadframe has a mount part, which has the wire connecting area (10), the connecting strip (3a, b) and an insertion opening,
- a separately manufactured thermal connecting part (4) is inserted into the insertion opening and is connected on its circumference to the mount part, wherein the thermal connecting part (4) has the chip mounting area (11),
- the housing (1) has a housing base body (1) which is formed from a molding compound and in which the leadframe (2) is embedded such that the electrical connecting strip (3a, b) is passed out of the housing base body, and a thermal connecting surface of the thermal connecting part (4) can be thermally connected from the outside,
- the housing base body (1) has a radiation outlet window (8), and the thermal connecting part (4) is embedded in the housing base body such that the chip mounting area (11) is arranged in the radiation outlet window (8), **characterized in that**
- the side walls (9) of the radiation outlet window (8) are in the form of reflector surfaces wherein the radiation outlet window (8) is extended in the direction of the wire connecting area (10) and has the wire connecting area (10), and
- the wire connecting area (10) is arranged at a higher level than the chip mounting area (11), when seen from the latter.

**2.** Housing (2) according to Claim 1, **characterized in that** the mount part has a bracket or eye into which the thermal connecting part (4) is linked.

**3.** Housing (2) according to Claim 1 or 2, **characterized in that** a crimped, riveted, soldered or welded connection is provided between the thermal connecting part (4) and the mount part.

**4.** Housing (2) according to one of Claims 1 to 3, **characterized in that** the thermal connecting part (4) contains copper, aluminum, molybdenum, iron, nickel or tungsten.

**5.** Housing (2) according to one of Claims 1 to 4, **characterized in that** the chip mounting area (11) is provided with a surface coating in order to improve the chip mounting.

**6.** Housing (2) according to Claim 5, **characterized in that** the surface coating for chip mounting comprises a silver or gold coating.

**7.** Housing (2) according to one of Claims 1 to 6, **characterized in that** the leadframe (2) contains copper or iron.

**8.** Housing (2) according to one of Claims 1 to 7, **characterized in that** the external electrical connecting strip (3a, b) has a surface coating in order to improve the component mounting characteristics.

**9.** Housing (2) according to Claim 8, **characterized in that** the surface coating to improve the component mounting characteristics comprises a silver, gold, tin or zinc coating.

**10.** Housing according to one of the preceding claims, **characterized in that** the housing can be surface mounted.

**11.** Radiation-emitting component having a radiation-emitting chip (5), **characterized in that** the radiation-emitting component has a housing according to one of Claims 1 to 10, wherein the chip (5) is mounted on the chip mounting area (11) of the thermal connecting part (4).

**12.** Radiation-emitting component according to Claim 11, **characterized in that** the chip (5) is a semiconductor chip.

**13.** Radiation-emitting component according to Claim 11 or 12, **characterized in that** the chip (5) is at least partially sheathed with a radiation-permeable compound (14), in particular a plastic compound, such as a casting resin or a molding compound.

**14.** Radiation-emitting component according to Claim 13, **characterized in that**

the plastic compound contains an epoxy resin, an acryl resin, a silicone resin or a mixture of these resins.

15. Radiation-emitting semiconductor component according to Claim 13 or 14,
**characterized in that**
the volume (V) of the radiation-permeable compound (14) is given by:

$$V \le q \cdot H,$$

where H is the height of the chip (5) and q is a scaling factor whose value is less than 10 mm$^2$ and is preferably 7 mm$^2$.

16. Radiation-emitting semiconductor component according to one of Claims 11 to 15,
**characterized in that**
the chip (5) is adhesively bonded or soldered to the chip mounting area (11).

17. Radiation-emitting semiconductor component according to Claim 16,
**characterized in that**
the chip (5) is mounted on the chip mounting area (11) by means of a hard solder.

18. Radiation-emitting semiconductor component according to Claim 17,
**characterized in that**
the melting temperature of the hard solder is greater than 260°C.

19. Radiation-emitting semiconductor component according to one of Claims 11 to 18,
**characterized in that**
the chip (5) is electrically conductively connected to the wire connecting area (10) by means of a wire connection (17).

20. Method for producing a radiation-emitting semiconductor component according to one of Claims 11 to 19,
**characterized by** the following steps:

- a mount part is provided,
- a thermal connecting part (4) which has a chip mounting area (11) is inserted into an insertion opening of the mount part,
- a radiation-emitting chip (5) is fitted to the chip mounting area (11),
- the mounting part (2) and the thermal connecting part (4) are embedded in a housing molding compound wherein
- the side walls (9) of the radiation outlet window (8) are shaped as reflector surfaces, wherein the radiation outlet window (8) is extended in the direction of the wire connecting area (10) and has the wire connecting area (10), and
- the wire connecting area (10) is arranged at a higher level than the chip mounting area (11), when seen from the latter.

21. Method according to Claim 20,
**characterized in that**
the thermal connecting part (4) is connected to the mount part by riveting, crimping or soldering.

22. Method according to Claim 20 or 21,
**characterized in that**
the chip (5) is fitted to the chip mounting area (11) before the mount part and the thermal connecting part (4) are embedded in the housing molding compound.

23. Method according to one of Claims 20 to 22,
**characterized in that**
the chip (5) is soldered to the chip mounting area (11), with the soldering temperature being greater than 260°C.

24. Method according to Claim 23,
**characterized in that**
the chip (5) is mounted on the chip mounting area (11) by means of a hard solder.

25. Method according to one of Claims 20 to 24,
**characterized in that**
the mount part (2) and the thermal connecting part (4) are embedded in a housing molding compound by means of an injection-molding or injection-compression method.

**Revendications**

1. Boîtier (2) pour un composant émettant un rayonnement comprenant un cadre conducteur, lequel possède au moins une zone de montage de puce (11), au moins une zone de raccordement de fil (10) et au moins une bande de raccordement électrique externe (3a, b), avec lequel

- le cadre conducteur possède une partie porteuse qui possède la zone de raccordement de fil (10), la bande de raccordement (3a, b) et une ouverture d'insertion,
- une partie de raccordement thermique (4) fabriquée séparément est introduite dans l'ouverture d'insertion et reliée du côté de son pourtour avec la partie porteuse, la partie de raccordement thermique (4) possédant la zone de montage de puce (11),

- le boîtier (1) possède un corps de base de boîtier (1), lequel est formé par une masse de moulage et dans lequel est encastré le cadre conducteur (2) de telle sorte que la bande de raccordement (3a, b) électrique soit amenée à l'extérieur du corps de base de boîtier et qu'une surface de raccordement thermique de la partie de raccordement thermique (4) puisse être raccordée thermiquement depuis l'extérieur,

- le corps de base de boîtier (1) possède une fenêtre de sortie du rayonnement (8) et la partie de raccordement thermique (4) est encastrée de telle sorte dans le corps de base de boîtier que la zone de montage de puce (11) est disposée dans la fenêtre de sortie du rayonnement (8),

**caractérisé en ce que**

- les parois latérales (9) de la fenêtre de sortie du rayonnement (8) sont façonnées comme des surfaces réfléchissantes, la fenêtre de sortie du rayonnement (8) étant élargie en direction de la zone de raccordement de fil (10) et entourant la zone de raccordement de fil (10), et

- la zone de raccordement de fil (10), vue depuis la zone de montage de puce (11), est disposée rehaussée par rapport à celle-ci.

2. Boîtier (2) selon la revendication 1, **caractérisé en ce que** la partie porteuse possède une pince ou un oeillet dans laquelle/lequel la partie de raccordement thermique (4) est liée.

3. Boîtier (2) selon la revendication 1 ou 2, **caractérisé en ce qu'**une liaison par sertissage, rivetage, brasage ou soudage est prévue entre la partie de raccordement thermique (4) et la partie porteuse.

4. Boîtier (2) selon l'une des revendications 1 à 3, **caractérisé en ce que** la partie de raccordement thermique (4) contient du Cu, de l'Al, du Mo, du Fe, du Ni ou du W.

5. Boîtier (2) selon l'une des revendications 1 à 4, **caractérisé en ce que** la zone de montage de puce (11) est munie d'un traitement de surface destiné à améliorer le montage de la puce.

6. Boîtier (2) selon la revendication 5, **caractérisé en ce que** le traitement de surface pour le montage de la puce comprend un revêtement en Ag ou en Au.

7. Boîtier (2) selon l'une des revendications 1 à 6, **caractérisé en ce que** le cadre conducteur (2) contient du Cu ou du Fe.

8. Boîtier (2) selon l'une des revendications 1 à 7, **ca-**

**ractérisé en ce que** la bande de raccordement électrique externe (3a, b) possède un traitement de surface destiné à améliorer les caractéristiques de montage du composant.

9. Boîtier (2) selon la revendication 8, **caractérisé en ce que** le traitement de surface destiné à améliorer les caractéristiques de montage du composant comprend un revêtement en Ag, en Au, en Sn ou en Zn.

10. Boîtier selon l'une des revendications précédentes, **caractérisé en ce qu'**il peut être monté en surface.

11. Composant émettant un rayonnement comprenant une puce émettrice de rayonnement (5), **caractérisé en ce qu'**il possède un boîtier selon l'une des revendications 1 à 10, la puce (5) étant fixée sur la zone de montage de puce (11) de la partie de raccordement thermique (4).

12. Composant émettant un rayonnement selon la revendication 11, **caractérisé en ce que** la puce (5) est une puce en semiconducteur.

13. Composant émettant un rayonnement selon la revendication 11 ou 12, **caractérisé en ce que** la puce (5) est au moins partiellement enveloppée par une masse laissant passer le rayonnement (14), notamment une masse en matière plastique, telle qu'une résine de coulée ou une matière moulée.

14. Composant émettant un rayonnement selon la revendication 13, **caractérisé en ce que** la masse en matière plastique est une résine époxy, une résine acrylique, une résine de silicone ou un mélange de ces résines.

15. Composant semiconducteur émettant un rayonnement selon la revendication 13 ou 14, **caractérisé en ce que** la relation suivante s'applique au volume (V) de la masse laissant passer le rayonnement (14) :

$$V \leq q \cdot H,$$

où H désigne la hauteur de la puce (5) et q est un facteur de mise à l'échelle dont la valeur est inférieure à 10 mm$^2$ et est de préférence égale à 7 mm$^2$.

16. Composant semiconducteur émettant un rayonnement selon l'une des revendications 11 à 15, **caractérisé en ce que** la puce (5) est collée ou brasée sur la zone de montage de puce (11).

17. Composant semiconducteur émettant un rayonnement selon la revendication 16, **caractérisé en ce**

**que** la puce (5) est fixée sur la zone de montage de puce (11) au moyen d'une brasure forte.

18. Composant semiconducteur émettant un rayonnement selon la revendication 17, **caractérisé en ce que** la température de fusion de la brasure forte est supérieure à 260 °C.

19. Composant semiconducteur émettant un rayonnement selon l'une des revendications 11 à 18, **caractérisé en ce que** la puce (5) est reliée électriquement à la zone de raccordement de fil (10) au moyen d'une liaison filaire (17).

20. Procédé de fabrication d'un composant semiconducteur émettant un rayonnement selon l'une des revendications 11 à 19, **caractérisé par** les étapes suivantes :

    - mise à disposition d'une partie porteuse,
    - introduction d'une partie de raccordement thermique (4) possédant une zone de montage de puce (11) dans une ouverture d'insertion de la partie porteuse,
    - dépose d'une puce (5) émettrice de rayonnement sur la zone de montage de puce (11),
    - encastrement de la partie porteuse (2) et de la partie de raccordement thermique (4) dans une masse de moulage du boîtier,
    - les parois latérales (9) de la fenêtre de sortie du rayonnement (8) étant façonnées comme des surfaces réfléchissantes, la fenêtre de sortie du rayonnement (8) étant élargie en direction de la zone de raccordement de fil (10) et entourant la zone de raccordement de fil (10), et
    - la zone de raccordement de fil (10), vue depuis la zone de montage de puce (11), étant disposée rehaussée par rapport à celle-ci.

21. Procédé selon la revendication 20, **caractérisé en ce que** la partie de raccordement thermique (4) est reliée à la partie porteuse par rivetage, sertissage ou brasage.

22. Procédé selon la revendication 20 ou 21, **caractérisé en ce que** la puce (5) est déposée sur la zone de montage de puce (11) avant l'encastrement de la partie porteuse et de la partie de raccordement thermique (4) dans la masse de moulage du boîtier.

23. Procédé selon l'une des revendications 20 à 22, **caractérisé en ce que** la puce (5) est brasée sur la zone de montage de puce (11), la température de brasage étant supérieure à 260 °C.

24. Procédé selon la revendication 23, **caractérisé en ce que** la puce (5) est fixée sur la zone de montage de puce (11) au moyen d'une brasure forte.

25. Procédé selon l'une des revendications 20 à 24, **caractérisé en ce que** l'encastrement de la partie porteuse (2) et de la partie de raccordement thermique (4) dans une masse de moulage du boîtier est réalisé au moyen d'un procédé de moulage par injection ou de moulage par transfert.

## FIG 1a

## FIG 1b

# FIG 2

# FIG 3

# FIG 4

# FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19536454
- DE 4017697 A1
- EP 1139439 A1
- WO 9820718 A1
- DE 19945675 A1
- WO 0055914 A1